Europäisches Patentamt

European Patent Office

Office européen des brevets

(11) Publication number: **0 283 007 B1**

(12) **EUROPEAN PATENT SPECIFICATION**

(45) Date of publication of patent specification: **22.01.92**    (51) Int. Cl.⁵: **C23C 16/44**, C23C 16/54

(21) Application number: **88104251.9**

(22) Date of filing: **17.03.88**

(54) **Chemical vapour deposition apparatus having a perforated head.**

(30) Priority: **17.03.87 JP 61811/87**

(43) Date of publication of application:
**21.09.88 Bulletin 88/38**

(45) Publication of the grant of the patent:
**22.01.92 Bulletin 92/04**

(84) Designated Contracting States:
**DE FR GB**

(56) References cited:
**US-A- 3 745 969**
**US-A- 4 499 853**
**US-A- 4 649 859**

**PATENT ABSTRACTS OF JAPAN, vol. 10, no. 287 (C-375)[2343], 30th September 1986; & JP-A-61 104 080 (HITACHI LTD) 22-05-1986**

**PATENT ABSTRACTS OF JAPAN, vol. 9, no. 218 (C-301)[1941], 5th September 1985; & JP-A-60 81 093 (NIPPON SHINKU GIJUTSU K.K.) 09-05-1985**

**PATENT ABSTRACTS OF JAPAN, vol. 1, no. 127 (E-77)[5546], 21-10-1977; & JP-A-52 60 570 (TOKYO SHIBAURA DENKI K.K.) 19-05-1977**

(73) Proprietor: **FUJITSU LIMITED**
**1015, Kamikodanaka Nakahara-ku**
**Kawasaki-shi Kanagawa 211(JP)**

(72) Inventor: **Mieno, Fumitake c/o Fujitsu Limited Patent Dep.**
**Kosugi Fujitsu Building 1812-10**
**Shimonumabe**
**Nakahara-ku Kawasaki-shi Kanagawa 211(JP)**

(74) Representative: **Greenstreet, Cyril Henry et al Haseltine Lake & Co. Hazlitt House 28 Southampton Buildings Chancery Lane London WC2A 1AT(GB)**

## Description

The present invention relates to a chemical vapour deposition apparatus particularly useful for producing a chemical vapour deposited film of a semiconductor device. It includes an improved form of perforated head for ejecting reaction gas onto an object to be processed, such as a silicon wafer.

Chemical vapour deposition is a process for forming a stable solid by decomposition of chemical vapours using heat, plasma, ultraviolet light or other energy sources. In the following, a thermal chemical vapour deposition will be described as a typical process of this category. The process is widely employed in fabrication steps of a semiconductor device, such as an MOS field effect transistor. For example, a silicon epitaxial layer is formed on a silicon wafer by a chemical vapour deposition method. The production yield and the quality of the associated semiconductor device essentially depend on the quality and the uniformity of the thickness of the silicon epitaxial layer thus formed. It is widely known that the hydrodynamic behaviour of the relevant reaction gas affects the process critically. In view of this point, the ejection head of a chemical vapour deposition apparatus for ejecting a stream of reaction gas onto the wafer is of considerable importance, particularly when the reaction gas flow is directed perpendicular to the surface of the wafer as in the case of a low-pressure silicon epitaxial process. This is because the quality and the uniformity of thickness of the silicon epitaxial layer formed is critically affected by the state of the reaction gas stream, which is substantially dependent on the hydrodynamic structure of the ejection head.

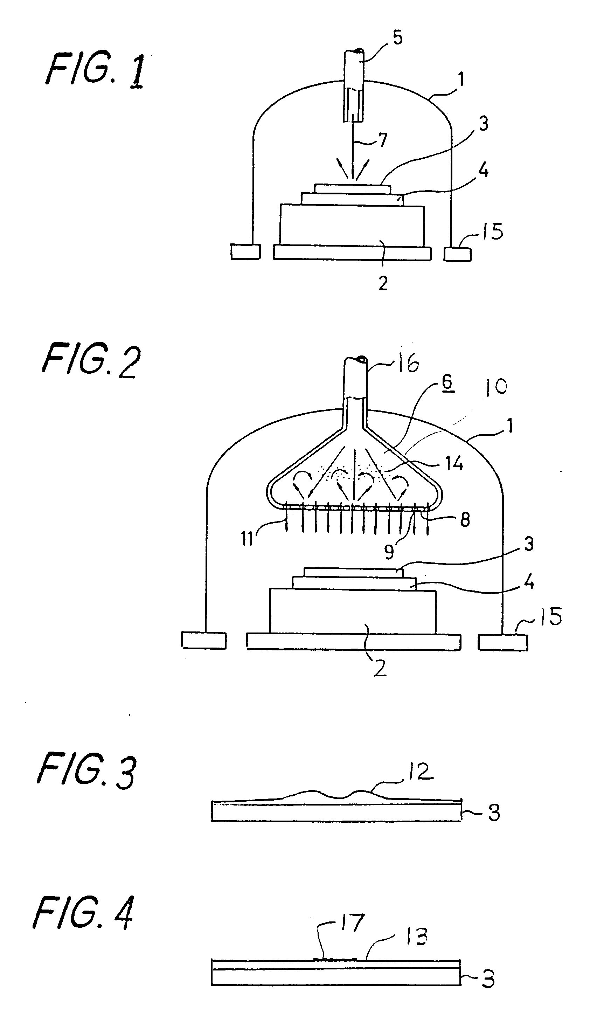

Fig. 1 and Fig. 2 are schematic cross-sectional views partially illustrating prior art low-pressure chemical vapour deposition apparatus. On a base plate 15, a bell jar 1 is set forming a reaction chamber thereinside. A mono-crystalline silicon wafer 3 is placed on a susceptor 4 which is mounted on a graphite heater 2. A stream 7 of gas is ejected downwardly from a nozzle 5 or a perforated head 6 onto the surface of the wafer 3 to form an epitaxial mono-crystalline silicon layer on the wafer 3. The nozzle 5 of Fig. 1 is a simple nozzle pipe, ejecting a stream 7 of gas directly impinging upon the surface of the wafer 3. The distribution of the reaction gas flow rate, namely the rate at which the gas molecules arrive at the surface of the wafer 3, has a maximum at the centre of the stream and declines toward the periphery. The wafer 3 is cooled by the gas stream, particularly at the centre portion of the stream, thus decreasing the thermal reaction rate of the reaction gas. As the result, an epitaxial silicon layer 12 formed on the wafer 3 is distributed as shown in a cross-section view in Fig. 3.

The perforated head 6 of Fig. 2 is an improved reaction gas ejecting means on the nozzle 5 of Fig. 1, comprising a conical housing 10 and a perforated plate 8 connected to each other. The reaction gas is fed through a pipe 16 which is connected to the top of the housing 10. The plate 8 is perforated with a matrix of a multiplicity of small holes 9. The reaction gas is injected inside the housing 10 through the pipe 16, and directed toward the perforated plate 8. The silicon layer 13 deposited on the wafer 3 has a favourably uniform thickness over the wafer 3, as shown in a cross-sectional view of Fig. 4, but has a whitish dull surface in the vicinity of the centre. The mechanism of the generation of the dull surface is believed to be as follows:

The gas molecules reaching the holes 9 can pass freely through the perforated plate 8 and are ejected in a stream 11 outside the perforated head 6. However, some of the gas molecules impinging approximately perpendicularly on the wall of the perforated plate 8, are reflected by the wall and flow in the reverse direction, forming turbulence. The turbulent flow of the reaction gas tends to generate silicon particles 14 which are finally deposited on to the surface of the wafer 3. The silicon particles 14 are believed to be generated by mutual collisions between reaction gas molecules. Such collisions occur easily when the gas flow is turbulent even though these gas molecules have a fairly long mean free path at a low reaction pressure. Finally, the silicon particles 14 are transferred on to the surface of the wafer 3. As a result, a portion 17 of the deposited epitaxial silicon layer 13 corresponding to the portion at and near the centre of the gas stream 11 has a rather rough surface having a whitish dull appearance. The portion 17 of the epitaxial silicon layer 13 has a polycrystalline structure which is grown due to the above-described transferred silicon particles 14 which act as crystal growth nuclei. Except for this dull surface, however, the deposited silicon layer 13 in the peripheral region has a mirror surface which implies a mono-crystalline structure of the silicon. This is believed to be due to the slow flow rate of the reaction gas in the relevant region, containing no turbulent flow. Desirably, therefore, the wafer 3 should be subjected to a uniformly distributed silicon reaction gas stream containing no silicon particles. A perforated head providing such a reaction gas stream, namely generating laminar gas flow thereinside and ejecting the flow onto the wafer, has been a long felt want in the field.

An object of the present invention is to provide means of forming a homogeneous chemical vapour deposition layer uniformly distributed on the surface of the relevant body to be coated.

Another object of the present invention is to provide a chemical vapour deposition apparatus with a perforated head capable of ejecting a reaction gas in a uniformly distributed laminar flow over the surface of the relevant body.

Still another object of the invention is to provide a low-pressure silicon epitaxial layer having a uniform thickness on a silicon wafer.

According to the invention these objects are achieved by an apparatus having the features set forth in claim 1 and by the process set forth in claim 9.

The present invention provides a perforated head comprising means for injecting a reaction gas supplied from a gas source into the space inside the perforated head, means, or housing, for guiding the ejected gas stream to convert the flow into a laminar gas flow, and a perforated plate having a number of small holes and facing the ejecting means. The reaction gas injected inside the perforated head is directed toward the inner surface of the housing, and is guided along the inner surface of the housing, being formed into a smoothly running laminar flow. The laminar gas flow then changes its direction along a rounded corner which is formed between the housing and the perforated plate, reaching the perforated plate at its peripheral portion. The laminar gas flow is ejected from the head through the small holes during the passage along the perforated plate toward the centre of the perforated plate. Thus, inside the perforated head, the reaction gas does not flow perpendicularly to the surface of the perforated plate, but rather flows parallel thereto and centripetally. As a result, no turbulent flow occurs during the passage of the gas from its injection inside the perforated head to its ejection out of the perforated head. Consequently, a homogeneous deposited layer having a uniform thickness is obtained.

The features and the advantages of the present invention will be apparent from the following description of preferred embodiments with reference to the accompanying drawings, wherein like reference numeral represent like parts, and in which;

Fig. 1
is a substantially schematic cross-sectional view, partially illustrating a prior art low-pressure chemical vapour deposition apparatus;

Fig. 2
is a substantially schematic cross-sectional view, partially illustrating a prior art low-pressure chemical vapour deposition apparatus;

Fig. 3
is a cross-section view of an epitaxial silicon layer formed on a wafer employing the chemical vapour deposition apparatus of Fig. 1;

Fig. 4
is a cross-section view of an epitaxial silicon layer formed on a wafer employing the chemical vapour deposition apparatus of Fig. 2;

Fig. 5
is a cross-sectional view of a low-pressure vapour deposition apparatus used in preferred embodiments of the present invention, schematically illustrating the system;

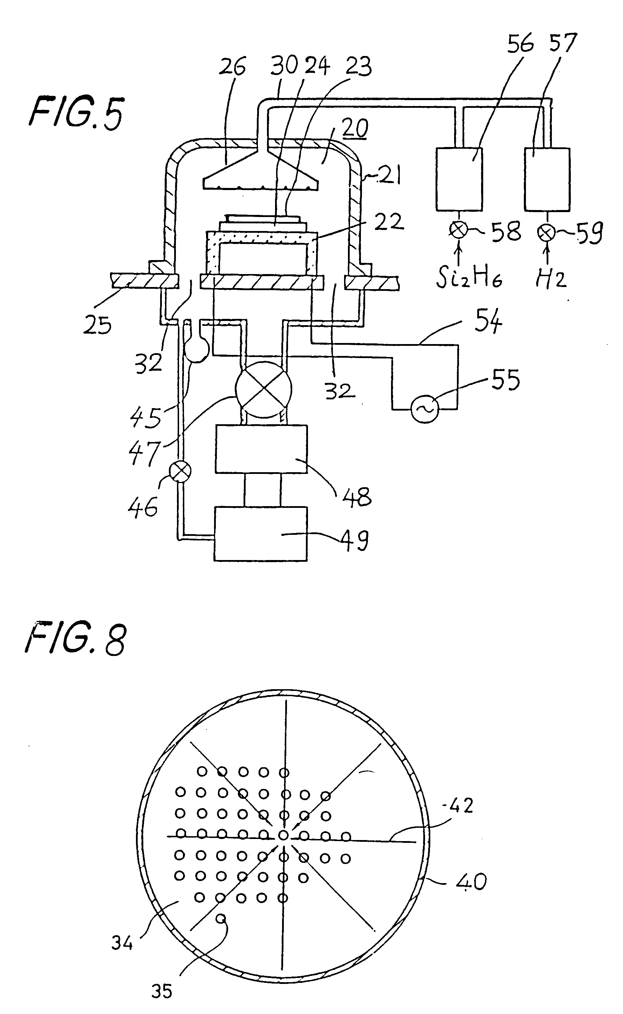

Fig. 6
is a cross-sectional view illustrating a first embodiment, namely the perforated head 26 of Fig. 5, in more detail;

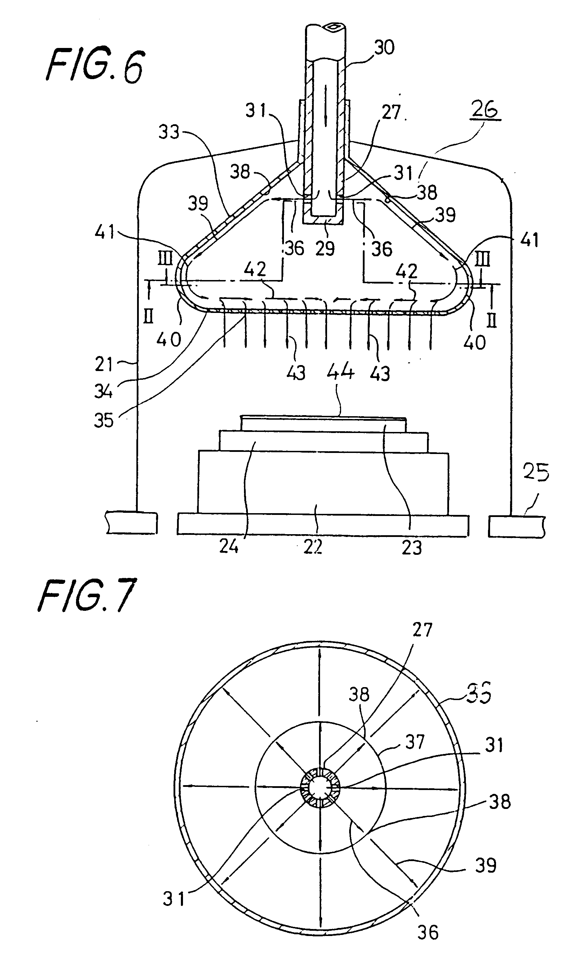

Fig. 7 and Fig. 8
are top views respectively taken along dot-dash lines II-II and III-III indicated in Fig. 6;

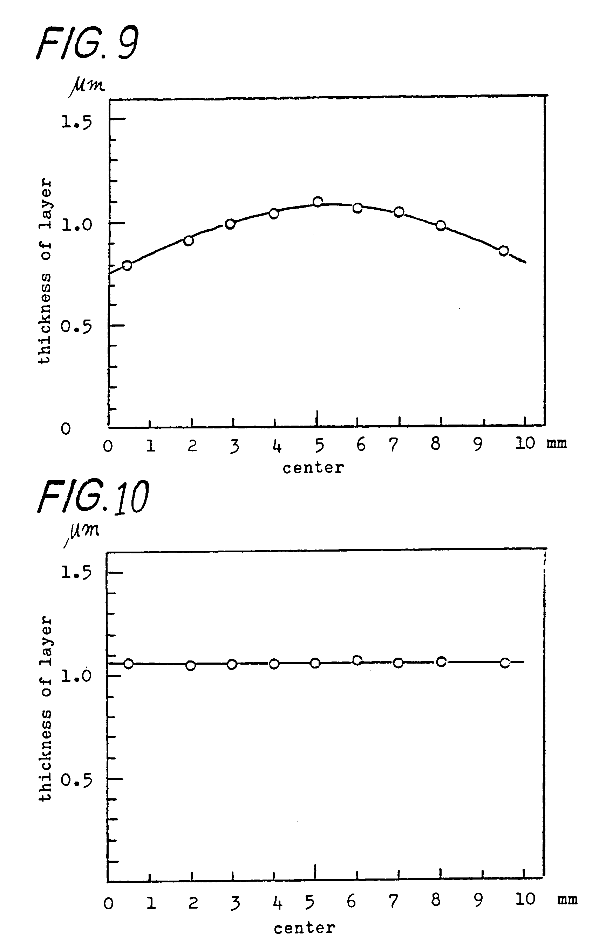

Fig. 9 and Fig, 10
are diagrams illustrating results of silicon epitaxial growth experiments performed respectively employing the prior art perforated head of Fig. 2 and the perforated head of the first embodiment of Fig. 6;

Fig. 11
is a cross-section view illustrating a second embodiment, namely, a modified perforated head of the first embodiment; and

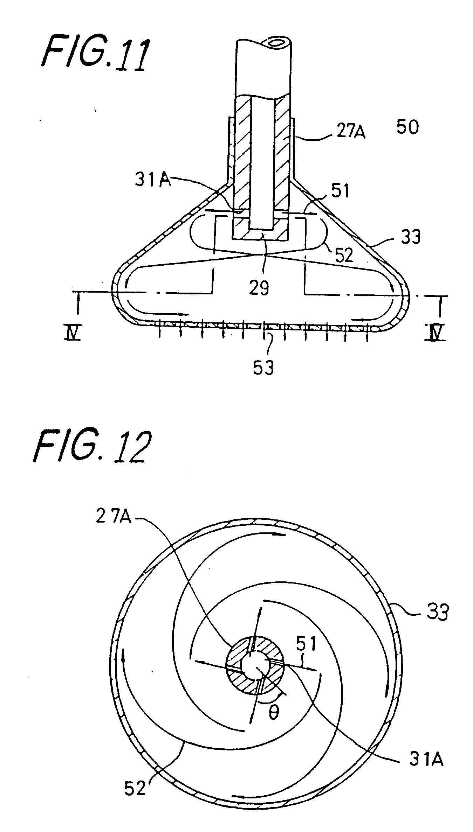

Fig. 12
is a top view taken along a dot-dash line IV-IV indicated in Fig. 11.

A low pressure vapour deposition apparatus used in preferred embodiments of the present invention is schematically illustrated in Fig. 5. A reaction chamber 20 comprises a bell jar 21, being mounted vacuum-tight on a metallic base plate 25. The inner diameter of the bell jar 21 may be 30 cm and the height 60 cm. A single crystal silicon wafer 23 to be deposited is placed on a susceptor 24 mounted on a graphite heater 22 which is controllably powered from an electrical power source 55 through wiring 54 to heat the wafer 23. Reaction gas mixture for vapour deposition is introduced into the reaction chamber 20 through a supply pipe 30, and flows onto the wafer 23 through a perforated head 26 disposed downwardly facing the wafer 23. Hydrogen ($H_2$) gas as a carrier gas, and disilane ($Si_2H_6$) gas as a silicon source gas, are respectively supplied from bottles (not shown), the supply and the flow rate of each gas being respectively controlled through valves 59 and 58 and mass-flow meters 57 and 56. These gas valves and mass-flow meters are arranged in parallel as represented in Fig. 5. The reaction chamber 20 is evacuated through several openings 32 in the base plate 25 by operating a conventional evacuating system connected thereto. The gas pressure inside the reaction chamber 20 is controlled by an evacuation system comprising a mechanical booster pump 48, a rotary pump 49, a vacuum gauge 45, a leak valve 46, and a main vacuum valve 47, arranged as shown in Fig. 5.

Fig. 6 is a cross-sectional view illustrating a first embodiment, namely, the perforated head 26 of Fig. 5, in more detail. Fig. 7 and Fig. 8 are top views taken along dash-dot lines II-II and III-III indicated in Fig. 6. The perforated head 26 comprises an ejection pipe 27, a housing 33 and a perforated plate 34 connected in the recited order as shown in Fig. 6. The ejection pipe 27 is connected to the supply pipe 30 at one end. In the vicinity of its other closed end 29 a number of ejection holes 31 (nozzles) open in radial directions equally spaced from each other by a fixed pitch angle as shown in Fig. 7 and in a plane perpendicular to the axis of the ejection pipe 27. The housing 33 has a shape approximately like a cone extending downwardly, and is connected at its circular bottom edge to the perforated plate 34, enclosing the ejection pipe 27, or at least the ejection holes 31. The portion of the housing 33 in the vicinity of the bottom edge is rounded inwardly with a large radius such that the inner surface of the housing adjacent to the bottom end is connected to the peripheral portion of the perforated plate 34 with a smoothly curved stream plane, forming a rounded circular corner 40. A number of small holes 35, namely nozzles, are disposed in the perforated plate 34 and uniformly distributed thereover as a matrix, for example as shown in Fig. 8. The dimensions of a perforated head having the above-described structure are, for example, 150 mm for the outer diameter of the perforated head 26, 2 mm for the inner diameter of the ejection nozzle 35, and 2 mm for the thickness of the perforated plate 34, the pitch of the ejection nozzles 35 disposed in a matrix being 10 mm. The material of the housing 33 and the perforated plate 34 is quartz.

The behaviour of reaction gas injected into the above-described perforated head will now be described referring to Fig. 6 and Fig. 7. The reaction gas ejected from the nozzles 31 in radial directions indicated by arrows 36 impinges on a portion of the inner surface of the housing 33 indicated by a circular line 37 at a position 38 on the inner surface. There the gas flow changes its direction along the inner surface. Then the gas flows along the inner surface downwardly as shown by arrows 39, to reach the rounded circular corner 40. During the transfer along the inner surface of the housing 33, the stream of the gas is adjusted to be a laminar flow which changes its direction smoothly along the rounded circular corner as indicated by arrows 41. Thereafter, the gas flows along the inner surface of the perforated plate 34, from the peripheral portion toward the centre position, namely centripetally, as shown by arrows 42. The gas still flows in a laminar flow state, and is ejected from the perforated head 26 through the small nozzles 35 as the flow passes over the nozzles 35 as shown by arrows 43. Before reaching the centre portion of the perforated plate 34, almost all the reaction gas will have been ejected from the perforated head 26, leaving little of the gas at the centre portion of the perforated plate 34. The volume of the residual gas is small and the flow rate of the gas is slow. Consequently, no turbulent flow is caused inside the space surrounded by the housing 33 and the perforated plate 34. The reaction gas ejected from the perforated head 26 toward the wafer 23, therefore, contains no silicon particles such as are generated by a turbulent flow of the reaction gas. The reaction gas is ejected perpendicularly to the wafer 23, which is heated by the graphite heater 22 up to a reaction temperature, with a flow rate uniformly distributed over the entire surface of the wafer 23. Thus, a substantially homogeneous, mono-crystalline silicon epitaxial layer 44 having a uniform thickness is formed on the wafer 23.

Results of silicon epitaxial growth experiments performed using the chemical vapour deposition apparatus illustrated in Fig. 5 are shown in the diagrams of Fig. 9 (employing the prior art perforated head of Fig. 2) and of Fig. 10 (employing the perforated head of Fig. 6), and will now be described. In the diagrams, the thickness of the silicon epitaxial layer is taken on the ordinate in $\mu$m, and the position along a diameter of the wafer 23 is taken on the abscissa in mm. The chemical vapour deposition conditions for both experiments were the same in both experiments, and were as follows: reaction temperature (temperature of the wafer)- 900 $^\circ$C

flow rate of disilane ($Si_2H_6$) gas      3 cc/min
flow rate of hydrogen ($H_2$) gas      10 l/min
wafer diameter      10 cm
distance between perforated plate and wafer      20 mm
reaction gas pressure      60 Torr ($8 \times 10^3$ Pa)

The dimensions of the perforated head were the same as those described above. The chemical vapour deposition time was 20 min.

The deposited silicon epitaxial layer formed by using the prior art perforated head had a whitish dull surface in the centre portion of the layer as described above. As shown in the diagram of Fig. 9, the fluctuation of the thickness was as large as $\pm$ 16% of the average thickness. In contrast to this, the silicon epitaxial layer deposited by using the perforated head of the first embodiment has a mirror surface over the entire surface, and an essentially uniformly distributed layer thickness as shown in the diagram of Fig. 10. the thickness remains within a range of $\pm$ 3 % of the average thickness. By comparing the two experimental results, it can be said that the perforated head of the first embodiment is substantially improved in the function.

In the above-described perforated head of the first embodiment, the ejection holes 31 are not limited to be disposed in a plane perpendicular to the axis of the ejection pipe 27. The ejection holes 31 may be disposed on a conical plane, for example, inclining outwardly and downwardly toward the perforated plate 34. The impinging angle of the ejected reaction gas between the normal to the inner surface of the housing 33 is enlarged to be favourable for forming a more smooth laminated reaction gas flow.

Fig. 11 is a cross-sectional view illustrating a second embodiment, namely, a modified perforated head of the first embodiment, and Fig. 12 is a top view taken along a dot-dash line IV-IV indicated in Fig. 11. The perforated head 50 of the second embodiment has an ejection pipe 27A having a closed end 29. In the vicinity of the end 29, a number of ejection holes 31A (nozzles) are opened in off-centered directions equally spaced from each other by a fixed pitch angle and on a plane perpendicular to the axis of the ejection pipe 27 as shown in Fig. 12. The direction of the axis of the ejection holes 31A is deviated from the corresponding radial direction by a fixed angle $\theta$. The rest of the structure of the perforated head 50 is the same at that of the perforated head 26 of the first embodiment. As a result, the reaction gas is ejected in direction indicated by arrows 51, and flows spirally along the inner surface of the housing 33 as indicated by arrows 52, and then flows centripetally along the inner surface of the perforated plate 34 in a shape of an eddy or in a spiral, being ejected outside through small nozzles 35 as indicated by arrows 53. The reaction gas flows in a more stable laminar flow and results in a more homogeneous epitaxial layer than that formed by using the perforated head 26 of the first embodiment.

In the present invention the perforated head comprises a first means of providing the reaction gas introduced inside the perforated head with predetermined initial directions, a second means for guiding the ejected reaction gas from the first means so as to flow in a laminar state, and a perforated plate receiving the laminar reaction gas flow and ejecting the flow outside the perforated head. The main object is to maintain the gas flow in a laminar stream by eliminating the generation of turbulence of the gas flow in the space enclosed inside the perforated head. Therefore, the shape of the housing is not limited to be conical. A spherical shape, for example, is also applicable. The cross-sectional shape of ejection holes 31 or 31A is not limited to be a circle: for example, a square can be used. As a whole, the perforated head desirably has the shape of a body of rotation.

Although epitaxial growth of silicon employing a perforated head according to the present invention has been described above, the perforated head is also applicable to other chemical vapour deposition processes. For example, the perforated head of the present invention can also be used to eliminate a native oxide layer adhered to the surface of a silicon wafer in order to clean the surface before the subsequent vapour deposition. For this purpose, a silicon wafer heated to a high temperature is showered with hydrogen ($H_2$) gas. The native oxide layer is easily eliminated in a shorter time and with higher reliability than is the case where a prior art perforated head is used. This is due to the homogeneous shower of hydrogen ($H_2$) gas generated by using the perforated head of the present invention.

## Claims

1. A chemical vapour deposition apparatus comprising a perforated head (26) for ejecting a flow of reaction gas on to an object to be processed, wherein the perforated head comprises a housing (33) having a base (34) with a plurality of small perforations therein facing said object, an upper part connected to the base by a rounded corner (40) and a gas ejection member (27) within the head facing said base and having a plurality of ejection nozzles (31) directed towards the inner surface of the housing upper part, the shape and position of the nozzles (31) and of the housing (33) being such that the reaction gas from the ejection member (27) is guided to flow over the inner surface of the housing towards its perforated base (34) in a state of laminar flow and to pass centripetally over the surface of the base and be ejected through the perforations therein.

2. A chemical vapour deposition apparatus according to claim 1, wherein said gas ejection nozzles (31) are disposed in a plane perpendicular to the axis of said ejection member and in radial directions, and are spaced from each other by a fixed pitch angle.

3. A chemical vapour deposition apparatus according to claim 1, wherein said gas ejection nozzles (31) are disposed in a conical surface inclined toward said perforated plate and are spaced from each other by a fixed pitch angle.

4. A chemical vapour deposition apparatus according to claim 1, wherein said gas ejection nozzles (31A) are disposed in a plane perpendicular to the axis of said ejection member and in directions deviated from respective radial directions by a fixed angle, and are spaced from each other by a fixed pitch angle.

5. A chemical vapour deposition apparatus according to claim 1, wherein said gas ejection nozzles (31) are disposed in a conical surface inclined toward said perforated plate and in directions deviated from respective radial directions by a fixed angle, and are spaced from each other with a fixed pitch angle.

6. A chemical vapour deposition apparatus according to any preceding claim, wherein said perforated head (26) has the shape of a body of rotation having a circular corner edge (40) which is rounded in the vicinity of said base (34).

7. A chemical vapour apparatus according to any preceding claim, wherein said perforated head (26) has an approximately conical shape having a circular corner edge (40) which is rounded.

8. A chemical vapour deposition apparatus according to claim 4 or claim 5, wherein said gas ejection nozzles (31) are so arranged that the reaction gas ejected therefrom flows spirally over the inner surface of said housing.

9. A chemical vapour deposition process which comprises directing a reaction gas towards the inner surface of the upper part of an ejection head having a base facing an object to be processed from a plurality of ejection nozzles in a gas injection member within said head and facing said base so that the gas passes in a state of laminar flow over said surface towards said base and changing the direction of said flow smoothly along the corner where said upper part joins said base so that it passes centripetally over and parallel to the inner surface of said base, whereby it is ejected through a plurality of small perforations in said base in a uniformly directed flow on to a face of said object to be processed.

**Revendications**

1. Appareil de dépôt chimique en phase vapeur comprenant une tête perforée (26) destinée à éjecter un courant de gaz réactionnel vers un objet à traiter, dans lequel la tête perforée comprend un boîtier (33) ayant une base (34) qui a plusieurs petites perforations tournées vers l'objet, une partie supérieure raccordée à la base par un coin arrondi (40) et un organe (27) d'éjection de gaz placé dans la tête, tourné vers la base, et ayant plusieurs buses d'éjection (31) dirigées vers la surface interne de la partie supérieure du boîtier, la configuration et la position des buses (31) et du boîtier (33) étant telles que le gaz réactif provenant de l'organe d'éjection (27) est guidé afin qu'il s'écoule sur la surface interne du boîtier vers sa base perforée (34) sous forme d'un écoulement laminaire, circule en direction centripète sur la surface de la base et soit éjecté par les perforations de celle-ci.

2. Appareil de dépôt chimique en phase vapeur selon la revendication 1, dans lequel les buses (31) d'éjection de gaz sont placées dans un plan perpendiculaire à l'axe de l'organe d'éjection et en directions radiales, et sont séparées les unes des autres par un angle fixe formant un pas.

3. Appareil de dépôt chimique en phase vapeur selon la revendication 1, dans lequel les buses (31) d'éjection de gaz sont disposées sur une surface conique inclinée vers la plaque perforée et sont séparées les unes des autres par un angle fixe formant un pas.

4. Appareil de dépôt chimique en phase vapeur selon la revendication 1, dans lequel les buses (31A) d'éjection de gaz sont disposées dans un plan perpendiculaire à l'axe de l'organe d'éjection et dans des directions qui s'écartent des directions radiales respectives d'un angle fixe, et sont séparées les unes des autres par un angle fixe formant un pas.

5. Appareil de dépôt chimique en phase vapeur selon la revendication 1, dans lequel les buses (31) d'éjection de gaz sont placées sur une surface conique inclinée vers la plaque perforée et dans des directions qui s'écartent des directions radiales respectives d'un angle fixe, et sont séparées les unes des autres d'un angle fixe formant un pas.

6. Appareil de dépôt chimique en phase vapeur selon l'une quelconque des revendications précédentes, dans lequel la tête perforée (26) a la forme d'un corps à symétrie de rotation ayant un bord circulaire de coin (40) qui est arrondi au voisinage de la base (34).

7. Appareil de dépôt chimique en phase vapeur selon l'une quelconque des revendications précédentes, dans lequel la tête perforée (26) a une forme approximativement conique ayant un bord de coin circulaire (40) qui est arrondi.

8. Appareil de dépôt chimique en phase vapeur selon la revendication 4 ou 5, dans lequel les buses (31) d'éjection de gaz sont disposées afin que le gaz réactif qui est éjecté s'écoule en spirale au-dessus de la surface interne du boîtier.

9. Procédé de dépôt chimique en phase vapeur, comprenant la projection d'un gaz réactif vers la surface interne de la partie supérieure d'une tête d'éjection ayant une base tournée vers un objet à traiter, par plusieurs buses d'éjection, dans un organe d'injection de gaz placé dans la tête et tourné vers la base, de manière que le gaz circule en formant un écoulement laminaire sur la surface, vers la base, et le changement de direction de l'écoulement progressivement le long du coin auquel la partie supérieure se raccorde à la base si bien que le gaz circule en direction centripète sur la surface interne de la base et parallèlement à celle-ci, et que le gaz est éjecté par plusieurs petites perforations formées dans la base, et forme un courant dirigé uniformément vers une face de l'objet à traiter.

**Patentansprüche**

1. Chemische Dampfabscheidungsvorrichtung mit einem perforierten Kopf (26) zum Ausstoß eines Flusses von Reaktionsgas auf ein zu bearbeitendes Objekt, wobei der perforierte Kopf umfaßt : ein Gehäuse (33) mit einer Basis (34) mit einer Vielzahl kleiner Perforationen darin, die dem Objekt gegenüberliegen, ein mit der Basis durch eine gerundete Ecke (40) verbundenes Oberteil und ein Gasausstoßglied (27) im Inneren des Kopfes, das der Basis gegenüberliegt und eine Vielzahl von Ausstoßdüsen (31) hat, die gegen die innere Oberfläche des Oberteils des Gehäuses gerichtet sind, wobei Form und Position der Düsen (31) und des Gehäuses (33) derart sind, daß das Reaktionsgas aus dem Ausstoßglied (27) geführt wird, um über die innere Oberfläche des Gehäuses Zu seiner perforierten Basis (34) in einem laminaren Flußzustand zu fließen, um zentripetal über die Oberfläche der Basis zu passieren, und um durch die darin befindlichen Perforationen ausgestoßen zu werden.

2. Chemische Dampfabscheidungsvorrichtung nach Anspruch 1, bei dem die Gasausstoßdüsen (31) in einer Ebene senkrecht zur Achse des Ausstoßgliedes und in radialen Richtungen angeordnet sind, und durch einen festen Abstandswinkel voneinander getrennt sind.

3. Chemische Dampfabscheidungsvorrichtung nach Anspruch 1, bei dem die Gasausstoßdüsen (31) in einer zu der perforierten Platte hin geneigten Kegelfläche angeordnet sind und durch einen festen Abstandswinkel voneinander getrennt sind.

4. Chemische Dampfabscheidungsvorrichtung nach Anspruch 1, bei dem die Gasausstoßdüsen (31A) in einer Ebene senkrecht zu der Achse des Ausstoßgliedes in Richtungen, die von den jeweiligen radialen Richtungen um einen festen Winkel abweichen, angeordnet sind und durch einen festen Abstandswinkel voneinander getrennt sind.

5. Chemische Dampfabscheidungsvorrichtung nach Anspruch 1, bei dem die Gasausstoßdüsen (31) auf einer zu der perforierten Platte hin geneigten Kegelfläche, in Richtungen, die von den jeweiligen radialen Richtungen um einen festen Winkel abweichen, angeordnet sind und durch einen festen Abstandswinkel voneinander getrennt sind.

6. Chemische Dampfabscheidungsvorrichtung nach einem der vorhergehenden Ansprüche, bei dem der perforierte Kopf (26) die Form eines Rotationskörpers besitzt, mit kreisförmiger Eckkante (40), die in der Nähe der Basis (43) abgerundet ist.

7. Chemische Dampfabscheidungsvorrichtung nach einem der vorhergehenden Ansprüche, bei dem der perforierte Kopf (26) eine angenähert kegelige Form hat, mit kreisförmiger Eckkante (40), die abgerundet ist.

8. Chemische Dampfabscheidungsvorrichtung nach Anspruch 4 oder Anspruch 5, bei dem die Gasausstoßdüsen (31) so angeordnet sind, daß das daraus ausgestoßene Reaktionsgas spiralförmig über die innere Oberfläche des Gehäuses fließt.

9. Chemischer Dampfabscheidungsprozess, der umfaßt :
Lenken eines Reaktionsgases gegen die innere Oberfläche des Oberteils eines Ausstoßkopfes, der eine Basis hat, die einem Objekt zugewandt ist, das zu bearbeiten ist von einer Vielzahl von Ausstoßdüsen, die in einem Gaseinspritzglied innerhalb des Kopfes angeordnet und der Basis so zugewandt sind, daß das Gas in einem Zustand laminaren Flusses über die Oberfläche zur Basis hin strömt, und gleichmäßiges Ändern der Richtung des Flusses längs der Ecke, wo das Oberteil auf die Basis trifft, so daß es zentripetal über die und parallel zu der inneren Oberfläche der Basis passiert, wodurch es durch eine Vielzahl von kleinen Perforationen in der Basis in einem gleichmäßig gerichteten Fluß auf die Oberfläche des zu bearbeitenden Objektes ausgestoßen wird.

FIG. 1

FIG. 2

FIG. 3

FIG. 4

FIG.5

FIG.8

# FIG.6

# FIG.7

*FIG.9*

*FIG.10*

*FIG.11*

27A

50

31A

51

33

52

33

29

IV          IV

53

*FIG.12*

27A

33

51

52          31A

θ